# EUROPEAN PATENT APPLICATION

(11) **EP 4 624 551 A1**
(43) Date of publication of application: **01.10.2025**
(21) Application number: 23893851.8
(22) Date of filing: 21.11.2023
(51) Int. Cl.: C09K 11/61, C09K 11/62, C09K 11/64, C09K 11/59, C09K 11/80, H01L 33/50, H01L 25/075

(54) **FULL-COLOR BIONIC FLUORESCENT COMPOSITION, FULL-COLOR BIONIC FLUORESCENT FILM, AND FULL-COLOR BIONIC LIGHT SOURCE**

(30) Priority: 21.11.2022 CN 202211456611
(71) Applicant: Sichuan Wholelight Technology Development Co., Ltd, Chengdu, Sichuan 610000 (CN)
(72) Inventor: YANG, Xiaoqin, Chengdu, Sichuan 610000 (CN); ZENG, Sheng, Chengdu, Sichuan 610000 (CN); ZENG, Jiaoyang, Chengdu, Sichuan 610000 (CN); CHEN, Hua, Chengdu, Sichuan 610000 (CN); LI, Gang, Chengdu, Sichuan 610000 (CN); CHEN, Daorong, Chengdu, Sichuan 610000 (CN); ZENG, Xiaodong, Chengdu, Sichuan 610000 (CN)
(74) Representative: Cabinet Netter
(86) International application number: PCT/CN2023/133056
(87) International publication number: WO 2024/109761

(57) **Abstract**

The present application relates to the field of optical lighting technology. Embodiments of the present application provide a full-color biomimetic phosphor composition, a full-color biomimetic phosphor film, and a full-color biomimetic light source. The full-color biomimetic phosphor composition includes: a first phosphor with a light-emitting wavelength of 480 nm to 500 nm, a second phosphor with a light-emitting wavelength greater than 500 nm and smaller than 620 nm, and a third phosphor with a light-emitting wavelength greater than or equal to 620 nm. A mass ratio of the first phosphor, the second phosphor, and the third phosphor is (15 to 70): (15 to 70): (13 to 70). By adjusting the ratio of a plurality of different phosphors whose light-emitting wavelengths are dispersedly distributed in the visible light band, the full-color biomimetic phosphor composition is excited to generate white light with low blue optical power, high color rendering index, and high red optical power. The white light highly simulates the natural light, increases comfort during use, and reduces harm to the human body.

## Description

The present application claims the priority of the Chinese patent application filed with the Chinese Patent Office on November 21, 2022 with an application number 202211456611.8 and titled "FULL-COLOR BIOMIMETIC PHOSPHOR COMPOSITION, FULL-COLOR BIOMIMETIC PHOSPHOR FILM, AND FULL-COLOR BIOMIMETIC LIGHT SOURCE", the entire contents of which are incorporated by reference in the present application.

### TECHNICAL FIELD

The present application relates to the technical field of optical lighting technology, more particularly to a full-color biomimetic phosphor composition, a full-color biomimetic phosphor film, and a full-color biomimetic light source.

### BACKGROUND

With the development of society, people's production and life activities under artificial light sources are increasing, and the time is getting longer and longer. LED light source is one of the most commonly used white light sources in production and life, with the advantages of high brightness, low energy consumption, and high safety.

However, the white light LED light source of the prior art still has some shortcomings. First, natural light is recognized as ideal lighting light. The white light generated by the white light LED light source is quite different from natural light, which makes people feel uncomfortable. Second, the white light generated by the white light LED light source has a high blue light content, which is harmful to people, such as causing cataracts and affecting sleep. Third, the white light generated by the white light LED light source has a low color rendering index, which is not realistic and deviates from the object and environment.

### TECHNICAL PROBLEMS

The purpose of the present application is to provide a full-color biomimetic phosphor composition, a full-color biomimetic phosphor film, and a full-color biomimetic light source to solve the technical problems that the white light generated by the white light LED light source in the prior art is greatly different from natural light and has high blue light and low color rendering index.

### TECHNICAL SOLUTIONS

In order to achieve the above application purpose, the first aspect of embodiments of the present application provides a full-color biomimetic phosphor composition. The full-color biomimetic phosphor composition of the embodiments of the present application comprises: a first phosphor, a second phosphor and a third phosphor. An emission wavelength of the first phosphor is 480 nm to 500 nm; an emission wavelength of the second phosphor is greater than 500 nm and smaller than 620 nm; and an emission wavelength of the third phosphor is greater than or equal to 620 nm. A mass ratio of the first phosphor, the second phosphor, and the third phosphor is (15 to 70) : (15 to 70) : (13 to 70).

In the full-color biomimetic phosphor composition of the embodiments of the present application, the first phosphor, the second phosphor, and the third phosphor with different emission wavelengths cooperate with one another, so that the white light generated by the full-color biomimetic phosphor composition comprises visible light of different bands in the range of 400 nm to 800 nm. Moreover, by adjusting the mass ratio of the first phosphor, the second phosphor, and the third phosphor, the absolute optical powers of the visible light of different bands in the white light are close to those in the natural light, and the absolute optical power of the blue light is reduced, thereby improving the similarity and color rendering index of the white light with the natural light, increasing the comfort of the white light when used, and improving the authenticity of the environment and objects.

In a second aspect of the embodiments of the present application, a full-color biomimetic phosphor film is provided. The full-color biomimetic phosphor film of the embodiments of the present application comprises a film-forming material and the full-color biomimetic phosphor composition according to the above embodiments of the present application dispersed in the film-forming material.

The full-color biomimetic phosphor film of the embodiments of the present application comprises the full-color biomimetic phosphor composition of the embodiments of the present application, so that the full-color biomimetic phosphor film of the embodiments of the present application is excited to generate a white light with high color rendering index and low blue light, which highly simulates the natural light.

In a third aspect of the embodiments of the present application, a full-color biomimetic light source is provided. The full-color biomimetic light source of the embodiments of the present application comprises at least one light-emitting unit, which comprises a chip and a full-color biomimetic phosphor film arranged on an optical path of the chip, and the full-color biomimetic phosphor film is the full-color biomimetic phosphor film according to the above embodiments of the present application.

The full-color biomimetic light source of the embodiments of the present application generates excitation light through the chip to excite the full-color biomimetic phosphor film of the embodiments of the present application to generate a white light. The white light generated by the full-color biomimetic light source of the embodiments of the present application has the characteristics of low absolute optical power of blue light, high absolute optical power of cyan light, high color rendering index and high approximation to natural light.

### BRIEF DESCRIPTION OF THE DRAWINGS

In order to more clearly illustrate the technical scheme in the embodiment of the present application, the following will briefly introduce the drawings required to be used in the embodiment or the prior art description. Obviously, the drawings described below are only some embodiments of the present application. For ordinary technicians in this field, other drawings can be obtained based on these drawings without creative work.
FIG. 1 is a schematic diagram of a light-emitting unit structure provided in an embodiment of the present application;
FIG.2 is a spectrum of a full-color biomimetic light source provided in Example C1;
FIG.3 is a spectrum of a full-color biomimetic light source provided in Example C2;
FIG.4 is a spectrum of a full-color biomimetic light source provided in Example C3;
FIG.5 is a spectrum of a full-color biomimetic light source provided in Example C4;
FIG.6 is a spectrum of a full-color biomimetic light source provided in Example C5;
FIG.7 is a spectrum of a full-color biomimetic light source provided in Example C6;
FIG.8 is a spectrum of a full-color biomimetic light source provided in Example C7;
FIG.9 is a spectrum of a full-color biomimetic light source provided in Example C8;
FIG. 10 is a spectrum of a full-color biomimetic light source provided in Example C9;
FIG.11 is a spectrum of a full-color biomimetic light source provided in Example C10;
FIG.12 is a spectrum of a full-color biomimetic light source provided in Example C11
FIG.13 is a spectrum of a full-color biomimetic light source provided by Example C12;
FIG.14 is a spectrum of a full-color biomimetic light source provided by Example C13;
FIG.15 is a spectrum of a full-color biomimetic light source provided by Example C14;
FIG.16 is a spectrum of a full-color biomimetic light source provided by Example C15; Part a of FIG.16 is a spectrum of a first light-emitting unit, Part b of FIG.16 is a spectrum of a second light-emitting unit, Part c of FIG.16 is a spectrum of the third light-emitting unit, Part d of FIG.16 is a composite spectrum of the first light-emitting unit to the third light-emitting unit, and Part e of FIG.16 is a spectrum of the existing dual-chip low-blue light full-spectrum light source;
FIG.17 is a spectrum of a full-color biomimetic light source provided by Comparative Example C1; and
FIG.18 is a spectrum of a full-color biomimetic light source provided by Comparative Example C2.

### DETAILED DESCRIPTION OF THE EMBODIMENTS

To clarify the technical problems to be solved by the present application, technical solutions, and beneficial effects, the present application is further described in detail in combination with the embodiments below. It should be understood that the specific embodiments described herein are only used to explain the present application and are not used to limit the present application.

In the present application, the term "and/or" describes the association relationship of the associated objects, indicating that there may be three relationships. For example, A and/or B can represent: A exists alone, A and B exist at the same time, and B exists alone. A and B can be singular or plural. The character "/" generally indicates that the associated objects before and after are in an "or" relationship.

In the present application, "at least one" means one or more, and "multiple" means two or more. "At least one of the following" or similar expressions refers to any combination of these items, including any combination of single or plural items. For example, "at least one of a, b or c", or "at least one of a, b and c", can all represent: a, b, c, a-b (i.e. a and b), a-c, b-c, or a-b-c, where a, b, c can be single or multiple.

The terms used in the embodiments of the present application are only for the purpose of describing specific embodiments and are not intended to limit the present application. The singular forms of "a" and "the" used in the embodiments of the present application and the appended claims are also intended to include plural forms unless the context clearly indicates other meanings.

The terms "first" and "second" are only used for descriptive purposes to distinguish purposes such as substances from each other, and cannot be understood as indicating or implying relative importance or implicitly indicating the number of technical features indicated. For example, without departing from the scope of the embodiments of the present application, the first XX can also be referred to as the second XX, and similarly, the second XX can also be referred to as the first XX. Thus, the features defined as "first" and "second" can explicitly or implicitly include one or more of the features.

In order to solve the technical problems that the white light generated by the white light LED light source in the prior art has high blue light, low color rendering index and large difference from natural light, the present application proposes the following technical solutions.

In a first aspect of embodiments of the present application, a full-color biomimetic phosphor composition is provided. The full-color biomimetic phosphor composition of the embodiments of the present application comprises: a first phosphor, a second phosphor, and a third phosphor. An emission wavelength of the first phosphor is 480 nm to 500 nm. An emission wavelength of the second phosphor is greater than 500 nm and smaller than 620 nm. An emission wavelength of the third phosphor is greater than or equal to 620 nm. A mass ratio of the first phosphor, the second phosphor, and the third phosphor is (15 to 70) : (15 to 70) : (13 to 70).

The first phosphor, the second phosphor, and the third phosphor, which have different emission wavelengths dispersedly distributed in the visible light band, cooperate with each other, so that the full-color biomimetic phosphor composition of the embodiments of the present application is excited to produce full-color white light. Moreover, by adjusting the mass ratio of the first phosphor, the second phosphor, and the third phosphor to (15 to 70): (15 to 70): (13 to 70), the absolute optical power value of the blue light in the white light is low, the absolute optical power value of the cyan light is high, and the natural light is highly simulated, while the color rendering index of the white light is improved.

It can be understood that the emission wavelength of the phosphor refers to the wavelength corresponding to the peak value of the main peak in the spectrum of the light generated by the phosphor being excited by photons.

In some embodiments, a first phosphor comprises a phosphor A. An emission wavelength of the phosphor A is 480 nm and/or 488 nm to 492 nm. The second phosphor comprises a phosphor B, and an emission wavelength of the phosphor B is 523 nm to 542 nm. The third phosphor comprises: a phosphor C, a phosphor D, a phosphor E, and a phosphor F, an emission wavelength of the phosphor C is 628 nm to 681 nm, an emission wavelength of the phosphor D is 718 nm to 722 nm, an emission wavelength of the phosphor E is 738 nm to 742 nm, and an emission wavelength of the phosphor F is 793 nm to 797 nm.

The phosphor A, the phosphor B, the phosphor C, the phosphor E, and the phosphor F with emission wavelengths dispersedly distributed in the visible light band make the white light generated by the full-color biomimetic phosphor composition of the present application comprise visible light of all bands within the range of 400 nm to 800 nm, optionally 400 nm to 700 nm, so that the white light further simulates natural light.

In a further embodiment, the phosphor B comprises a phosphor B1 and a phosphor B2. An emission wavelength of the phosphor B1 is 523 nm to 527 nm, and an emission wavelength of the phosphor B2 is 538 nm to 542 nm. The phosphor C comprises: a phosphor C1, a phosphor C2, and a phosphor C3. An emission wavelength of the phosphor C1 is 628 nm to 632 nm, an emission wavelength of the phosphor C2 is 658 nm to 662 nm, and an emission wavelength of the phosphor C3 is 677 nm to 681 nm.

In the exemplary embodiment, the phosphor A comprises A1 and A2, an emission wavelength of the phosphor A1 is 480 nm; an emission wavelength of the phosphor A2 is 490 nm. The emission wavelength of the phosphor B1 may be 525 nm, the emission wavelength of the phosphor B2 may be 540 nm, the emission wavelength of the phosphor C1 may be 630 nm, the emission wavelength of the phosphor C2 may be 660 nm, the emission wavelength of the phosphor C3 may be 679 nm, the emission wavelength of the phosphor D may be 720 nm, the emission wavelength of the phosphor E may be 740 nm, and the emission wavelength of the phosphor F may be 795 nm.

The first phosphor, the second phosphor, and the third phosphor can be separated from each other or mixed with each other. By separating the first phosphor, the second phosphor, and the third phosphor, the mass ratio of the phosphors with different emission wavelengths in the full-color biomimetic phosphor composition of the present application can be flexibly adjusted according to demand.

For example, in some embodiments, a mass ratio of the first phosphor, the second phosphor, and the third phosphor may be controlled to be (15 to 70): (15 to 70): (13 to 60), optionally be (25 to 60): (25 to 55): (13 to 60), and further optionally be (31 to 40): (31 to 40): (13 to 60). A mass ratio of the phosphor B1 and the phosphor B2 in the second phosphor can also be controlled to be (20 to 85): (10 to 85), optionally be (30 to 75): (20 to 75), and further optionally be (35 to 70): (25 to 70). A mass ratio of the phosphor C1, the phosphor C2, the phosphor C3, the phosphor D, the phosphor E, and the phosphor F in the third phosphor can also be controlled to be (3 to 35): (1 to 45) (3 to 60): (7 to 90): (7 to 60): (1 to 70), optionally be (7 to 30): (3 to 40) (3 to 50): (10 to 90): (10 to 60): (1 to 60), and further optionally be (7 to 20): (3 to 30) (3 to 40): (20 to 80): (20 to 50): (1 to 50).

By controlling the mass ratio of the first phosphor, the second phosphor, and the third phosphor, as well as the mass ratio of components of the second phosphor and the mass ratio of components of the third phosphor within the range, the absolute optical power values of different bands of white light generated by the full-color biomimetic phosphor composition of the embodiments of the present application can be adjusted, and the spectrum of the generated white light can be optimized, for example, in the generated white light, the red light in the wavelength range of 640 nm to 700 nm has high optical power, the optical power of the blue light is lower, so that the generated white light is closer to natural light, and the comfort of the white light when applied to lighting and the authenticity of the environment and objects are improved, and the harm to the human body is reduced.

In some embodiments, the phosphor C in the third phosphor forms a first mixture with the first phosphor and the second phosphor; and the phosphor D, the phosphor E, and the phosphor F in the third phosphor form a second mixture. The first mixture is provided separately from the second mixture.

In a further embodiment, the emission wavelength of the phosphor A in the first mixture may be 490 nm (A2), the phosphor B comprises the phosphor B3, the emission wavelength of the phosphor B3 may be 532 nm to 537 nm, specifically 535 nm, the phosphor C may comprise the phosphor C2 as described in the above, an emission wavelength of the phosphor C2 may be 658 nm to 662 nm, specifically 660 nm. AN emission wavelength of the phosphor D in the second mixture may be 720 nm, an emission wavelength of the phosphor E may be 740 nm, and an emission wavelength of the phosphor F may be 795 nm.

By dividing the full-color biomimetic phosphor composition into a first mixture and a second mixture which are separately provided, the first mixture and the second mixture contain components with different emission wavelengths, and when forming a film, the first mixture and the second mixture can be formed into films separately, so that the mass ratio of the first mixture and the second mixture can be flexibly adjusted, and then the spectrum of the white light emitted by the full-color biomimetic phosphor composition can be adjusted to optimize the spectral distribution of the generated white light, so that the white light is closer to natural light.

In some embodiments, a mass ratio of the phosphor A, the phosphor B, and the phosphor C in the first mixture can be controlled to be (10 to 80): (15 to 85): (1 to 40), optionally be (10 to 70): (15 to 85): (1 to 35), and further optionally be (15 to 60): (20 to 75): (1 to 30). A mass ratio of the phosphor D, the phosphor E, and the phosphor F in the second mixture can also be controlled to be (20 to 120): (10 to 90): (1 to 100), optionally be (30 to 100): (15 to 70): (1 to 80), and further optionally be (40 to 90): (20 to 60): (1 to 70).

By controlling the mass ratio of components in the first mixture and the mass ratio of components in the second mixture, the spectrum of the generated white light can be adjusted. By controlling the mass ratio of components in the first mixture and the mass ratio of components in the second mixture within this range, the spectrum of the generated white light can be optimized. For example, the mass ratio of the phosphor C in the first mixture, such as phosphor C2, can be increased, so that the white light has higher optical power of the red light in the wavelength range of 640 nm to 700 nm, thus being closer to the natural light.

In some embodiments, the first phosphor may be specifically GaYAG phosphor. In an exemplary embodiment, the GaYAG phosphor may be gallium-doped yttrium aluminum gamet, such as yttrium aluminum gallium oxide [Y₃(Al,Ga)₅O₁₂]. For example, the phosphor A (such as A1 or A2) may be gallium-doped yttrium aluminum garnet, such as yttrium aluminum gallium oxide [Y₃(Al,Ga)₅O₁₂].

In some embodiments, the second phosphor may be an oxynitride phosphor. In an exemplary embodiment, the oxynitride phosphor may be, but is not limited to, BaSi₂O₂N₂ (barium silicon oxynitride, 1222). For example, the phosphor B (specifically B1, B2, or B3) may be BaSi₂O₂N₂ (barium silicon oxynitride, 1222).

In some embodiments, the third phosphor may comprise at least one of nitride red powder and fluoride red powder. In the exemplary embodiment, nitride red powder may comprise, but is not limited to (Ca,Sr)AlSiN₃ (calcium strontium aluminum silicon nitride, 1113), and fluoride red powder may comprise, but is not limited to K₂SiF₆:Mn⁴⁺ (potassium fluorosilicate). For example, the phosphor C (specifically C1, C3, or C3), the phosphor D, the phosphor E, and the phosphor F may comprise at least one of (Ca,Sr)AlSiN₃ and K₂SiF₆:Mn⁴⁺.

In addition, the phosphors of various emission wavelengths, such as the phosphor A, the phosphor B, the phosphor C, the phosphor D, the phosphor E, and the phosphor F, can be directly purchased from the market according to the emission wavelength.

It should be noted that the specific number of compounds comprised in any of the phosphors A, the phosphor B, the phosphor C, the phosphor D, the phosphor E, or the phosphor F is not limited, and may comprise only a single pure compound or a mixture of multiple compounds. For example, the phosphor B may also comprise phosphor B1 and the phosphor B2; the phosphor C may also comprise the phosphor C1, the phosphor C2, and the phosphor C3. It can be understood that the phosphor B1, the phosphor B2, the phosphor C1, the phosphor C2, and the phosphor C3 may also comprise a single pure compound or a mixture of multiple compounds. For example, the phosphor C1 may be (Ca,Sr)AlSiN₃ or a mixture of (Ca,Sr)AlSiN₃ and K₂SiF₆:Mn⁴⁺.

In the full-color biomimetic phosphor composition in the above embodiments, particle sizes of the first phosphor, the second phosphor, and the third phosphor are independently smaller than or equal to 50 µm, optionally be 5 µm to 50 µm, and further optionally be 10 µm to 25 µm.

The particle sizes of the first phosphor, the second phosphor, and the third phosphor are controlled within this range, so that after the full-color biomimetic phosphor composition of the embodiments of the present application is formed into a film, the uniformity of the film layer is better and the light refractive index is smaller, so as to improve the luminous efficiency of the light source made.

A second aspect of embodiments of the present application provides a full-color biomimetic phosphor film. The full-color biomimetic phosphor film of the embodiments of the present application comprises a film-forming material and a full-color biomimetic phosphor composition of the embodiments of the present application dispersed in the film-forming material.

The white light generated by the full-color phosphor film of the embodiments of the present application when excited is full-color white light, and its spectral distribution in the visible light band is highly similar to natural light.

In some embodiments, the full-color biomimetic phosphor film of the embodiments of the present application is a single film layer of a film layer. By controlling the full-color biomimetic phosphor film of the embodiments of the present application to be a single film layer, the full-color biomimetic phosphor composition described above is mixed together during production to produce the full-color biomimetic phosphor film of the embodiments of the present application, the operation process is simple, the product quality has good reproducibility, and it is easy to produce.

In some embodiments, the film-forming material may be a silica gel or an epoxy resin. These film-forming materials such as silica gel have excellent properties, such as good light transmittance, resistance to atmospheric aging, and resistance to ultraviolet aging, so that the full-color biomimetic phosphor film of the present application has good light transmittance and is not easy to turn yellow due to aging during use.

In some embodiments, the full-color biomimetic phosphor film of the embodiments of the present application may comprise a composite film layer in which two or more single film layers are stacked. In the composite film layer, the film thickness of the single film layer may be smaller, and the components contained in different single film layers may be the same or different, and the full-color biomimetic phosphor composition components contained in the full-color biomimetic phosphor film may be flexibly adjusted according to the luminous efficiency and the spectrum of white light.

The full-color biomimetic phosphor film of the embodiments of the present application may be formed by a film pressing method and/or a spray coating method. When the full-color biomimetic phosphor film of the embodiments of the present application is the above described composite film layer, in a case that the film is formed by the film pressing method, a plurality of single film layers may be prepared first, and then the plurality of single film layers may be stacked and arranged in sequence, and the plurality of single film layers may be composited to form a full-color biomimetic phosphor film by vacuum pressing and other methods. In a case that the film is formed by the spray coating method, the single film layers may be formed by spraying layer by layer in sequence, thereby forming the above-mentioned composite film layer.

It should be noted that when the full-color biomimetic phosphor film of the embodiments of the present application is the above-mentioned composite film layer, the arrangement order of the multiple single film layers in the composite film layer is not limited, and may be arranged in sequence according to the order of the refractive index of the single film layer, or may be arranged in sequence according to the order of the emission wavelength.

In some embodiments, the full-color biomimetic phosphor film of the embodiments of the present application is the above-mentioned composite film layer, which comprises: a first film layer, a second film layer, and a third film layer arranged in a stacked manner, the first film layer comprises a first phosphor, the second film layer comprises a second phosphor, and the third film layer comprises a third phosphor. The first phosphor, the second phosphor, and the third phosphor are the first phosphor, the second phosphor, and the third phosphor of the above embodiments of the present application, and are not repeated herein.

By making the first film layer comprise the first phosphor, the second film layer comprise the second phosphor and the third film layer comprise the third phosphor, the mass ratio of the first phosphor, the second phosphor, and the third phosphor, the concentration of the first phosphor, the concentration of the second phosphor, and the concentration of the third phosphor may be flexibly adjusted during film formation, so that the generated white light spectrum is closer to natural light.

In some embodiments, the concentration of the first phosphor in the first film layer may be controlled to be 30% to 85%, optionally be 40% to 75%, and further optionally be 60% to 69%. The concentration of the first phosphor is the proportion of the mass of the first phosphor in the total mass of the first phosphor and the film-forming material.

The concentration of the second phosphor in the second film layer may also be controlled to be 30% to 85%, optionally be 45% to 75%, and further optionally be 60% to 69%. The concentration of the second phosphor is the proportion of the mass of the second phosphor in the total mass of the second phosphor and the film-forming material.

The concentration of the third phosphor in the third film layer may also be controlled to be 40% to 87%, optionally be 50% to 80%, and further optionally be 60% to 69%. The concentration of the third phosphor is the proportion of the mass of the third phosphor in the total mass of the third phosphor and the film-forming material.

The concentrations of the first phosphor, the second phosphor, and the third phosphor determine the color temperature of the generated white light. Under the conditions of a certain phosphor ratio and a certain film thickness, the higher the concentration, the lower the color temperature, and the lower the concentration, the higher the color temperature.

In other embodiments, the full-color biomimetic phosphor film of the embodiments of the present application is the above-mentioned composite film layer, which comprises a fourth film layer and a fifth film layer stacked, the fourth film layer comprises a first mixture, and the fifth film layer comprises a second mixture. The first mixture and the second mixture are the first mixture and the second mixture in the above embodiments of the present application, which will not be repeated here.

In the white light source of the prior art, the optical power value of red light with a wavelength greater than 640 nm is difficult to increase. The second mixture mainly produces red light. Through the fourth film layer and the fifth film layer, the proportion of the second mixture may be flexibly adjusted according to the luminous efficiency, so as to increase the optical power value of red light with a wavelength greater than 640 nm in the white light generated by the full-color biomimetic phosphor film of the embodiments of the present application, and improve the similarity between the white light and natural light.

In some embodiments, the concentration of the first mixture in the fourth film layer may be controlled to be 40% to 85%, optionally 40% to 80%, and further optionally 40% to 75%. The concentration of the first mixture is the proportion of the mass of the first mixture in the total mass of the first mixture and the film-forming material. The concentration of the second mixture in the fifth film layer may also be controlled to be 15% to 85%, optionally 20% to 80%, and further optionally 30% to 75%. The concentration of the second mixture is the proportion of the mass of the second mixture in the total mass of the second mixture and the film-forming material.

Controlling the concentrations of the first mixture and the second mixture within this range may make the spectrum of different bands in the white light generated by the full-color biomimetic phosphor film of the embodiments of the present application closer to natural light.

In some embodiments, the full-color biomimetic phosphor film of the embodiments of the present application may be formed by film pressing and/or spray coating.

In some embodiments, the full-color biomimetic phosphor film of the embodiments of the present application is formed by a film pressing method, and the film thickness may be controlled to be 0.06 mm to 0.15 mm. In further examples, the film thickness of the first film layer, the second film layer, and the third film layer may be controlled to be 0.06 mm to 0.15 mm independently. In other examples, the film thickness of the fourth film layer and the fifth film layer may also be controlled to be 0.06 mm to 0.15 mm, respectively.

In some embodiments, the full-color biomimetic phosphor film of the embodiments of the present application is formed by a spray coating method, and the film thickness may be controlled to be 0.001 mm to 0.01 mm, optionally be 0.002 mm to 0.006 mm, and further optionally be 0.002 mm to 0.003 mm. In further examples, the film thicknesses of the first film layer, the second film layer, and the third film layer may be controlled to be 0.06 mm to 0.15 mm independently, optionally be 0.002 mm to 0.006 mm independently, and further optionally be 0.002 mm to 0.003 mm independently. In other examples, the thickness of the fourth film layer and the fifth film layer may also be controlled to be 0.001 mm to 0.01 mm, optionally 0.002 mm to 0.006 mm, and further optionally 0.002 mm to 0.003 mm.

The thicknesses of the first film layer, the second film layer, and the third film layer, or the thicknesses of the fourth film layer and the fifth film layer are controlled within these ranges, close to the particle sizes of the full-color biomimetic phosphor composition particles, which may further reduce the refraction of the excitation light when propagating in each single film layer, so that the excitation light may reach each single film layer to the maximum extent, and meanwhile reduce the refraction of the visible light generated by the excitation of the phosphor in each single film layer when propagating in different single film layers, so that the visible light may reach the surface of the full-color biomimetic phosphor film away from the chip to the maximum extent, thereby improving the luminous efficiency of the full-color biomimetic phosphor film and the optical power of the white light emitted. The thicknesses of the first film layer, the second film layer, and the third film layer may be the same or different, and those skilled in the art may adjust the film thickness as needed or according to the luminous efficiency. Correspondingly, the thicknesses of the fourth film layer and the fifth film layer may be the same or different, and the specific selection may be made according to actual needs.

In a third aspect of the embodiments of the present application, a full-color biomimetic light source is provided. The full-color biomimetic light source of the embodiments of the present application comprises at least one light-emitting unit, which comprises a chip and a full-color biomimetic phosphor film arranged on an optical path of the chip, and the full-color biomimetic phosphor film is the full-color biomimetic phosphor film of the above embodiments of the present application.

The full-color biomimetic light source of the embodiments of the present application generates excitation light through the chip to excite the full-color biomimetic phosphor film of the embodiments of the present application to generate white light with low blue light, high optical power of red light in a band of 640 nm to 700 nm, and high color rendering index. The white light highly simulates natural light, which increases the comfort of the human body in use.

In some embodiments, it is known from spectral detection that the white light generated by the full-color biomimetic light source has any of the following spectral characteristics:
an absolute spectral power value of a violet light in a band of 380 nm to 435 nm is smaller than 0.45;
an absolute spectral power value of a blue light in a band of 435 nm to 475 nm is greater than 0.40 and smaller than 0.80;
an absolute spectral power value of a cyan light in a band of 475 nm to 492 nm is greater than 0.30;
an absolute spectral power value of an orange light in a band of 597 nm to 622 nm is greater than 0.80; and
an absolute spectral power value of a red light in a band of 622 nm to 700 nm is greater than 0.70.

Further testing revealed that a color temperature of white light generated by the full-color biomimetic light source of embodiments of the present application is smaller than 4000 K, an absolute optical power value of purple light in a band of 380 nm to 435 nm is smaller than 0.40, an absolute optical power value of blue light in a band of 435 nm to 475 nm is smaller than 0.65, an absolute optical power value of cyan light in a band of 475 nm to 492 nm is greater than 0.30, an absolute optical power value of green light in a band of 492 nm to 577 nm is smaller than 0.7, an absolute optical power value of yellow light in a band of 577 nm to 597 nm is smaller than 0.80, an absolute optical power value of orange light in a band of 597 nm to 622 nm is greater than 0.80, and an absolute spectral power of red light in a band of 622 nm to 700 nm is greater than 0.80.

Furthermore, a color temperature of the white light generated by the full-color biomimetic light source of the embodiments of the present application is 2700 K to 3000 K, an absolute optical power value of the purple light in a band of 380 nm to 435 nm is smaller than 0.35, an absolute optical power value of the blue light in a band of 435 nm to 475 nm is greater than 0.40, an absolute optical power value of the cyan light in a band of 475 nm to 492 nm is greater than 0.45, an absolute optical power value of the green light in a band of 492 nm to 577 nm is greater than 0.50, an absolute optical power value of the yellow light in a band of 577 nm to 597 nm is greater than 0.75, and an absolute spectral power of the red light in a band of 622 nm to 700 nm is greater than 0.80.

In other embodiments, the color temperature of white light generated by the full-color biomimetic light source of the embodiments of the present application is 4000 K to 4200 K, an absolute optical power value of purple light in a band of 380 nm to 435 nm is smaller than 0.40, an absolute optical power value of blue light in a band of 435 nm to 475 nm is smaller than 0.65, an absolute optical power value of cyan light in a band of 475 nm to 492 nm is greater than 0.60, an absolute optical power value of green light in a band of 492 nm to 577 nm is greater than 0.65, an absolute optical power value of yellow light in a band of 577 nm to 597 nm is greater than 0.80, an absolute optical power value of orange light in a band of 597 nm to 622 nm is greater than 0.8, and an absolute spectral power of red light in a band of 622 nm to 700 nm is greater than 0.80.

In other embodiments, the color temperature of white light generated by the full-color biomimetic light source of the embodiments of the present application is 5500 K to 6000 K, an absolute optical power value of purple light in a band of 380 nm to 435 nm is smaller than 0.45, an absolute optical power value of blue light in a band of 435 nm to 475 nm is smaller than 0.80, an absolute optical power value of cyan light in a band of 475 nm to 492 nm is greater than 0.70, an absolute optical power value of green light in a band of 492 nm to 577 nm is greater than 0.80, an absolute optical power value of yellow light in a band of 577 nm to 597 nm is greater than 0.80, an absolute optical power value of orange light in a band of 597 nm to 622 nm is greater than 0.80, and an absolute spectral power of red light in a band of 622 nm to 700 nm is greater than 0.70.

In the white light LED light source of the prior art, under different color temperature conditions, the optical power of red light is difficult to increase. At low color temperature (color temperature being 2700 K to 3200 K), the optical powers of blue light and the cyan light are difficult to increase. At high color temperature (such as color temperature above 4000K), the optical power of blue light is difficult to reduce, and the optical power of cyan light is difficult to reduce, so that the generated white light has a low similarity with natural light. Under different color temperatures of the white light generated by the full-color biomimetic light source of the embodiments of the present application, the optical powers of different bands are controlled to be within the above ranges, so that the white light generated by the full-color biomimetic light source of the embodiments of the present application highly simulates natural light.

The full-color biomimetic phosphor film arranged on the optical path of the chip may be the above single film layer or the above composite film layer formed by multiple single film layers. In some embodiments, the full-color biomimetic phosphor film comprises a composite film layer, and the single film layers within the composite film layer can be arranged sequentially away from the chip in an order of increasing refractive index. That is, a single film layer with a smaller refractive index is positioned closer to the chip, while a single film layer with a larger refractive index is placed further away from the chip. By arranging a single film layer with a small refractive index close to the chip, the light propagates in the light source from the optically sparse medium to the optically dense medium, avoiding the problem that the incident angle of the light is greater than the critical angle of total reflection and is reflected when the light propagates from the optically dense medium to the optically sparse medium, resulting in the light being unable to emit out of the light-emitting unit and the low brightness of the full-color biomimetic light source.

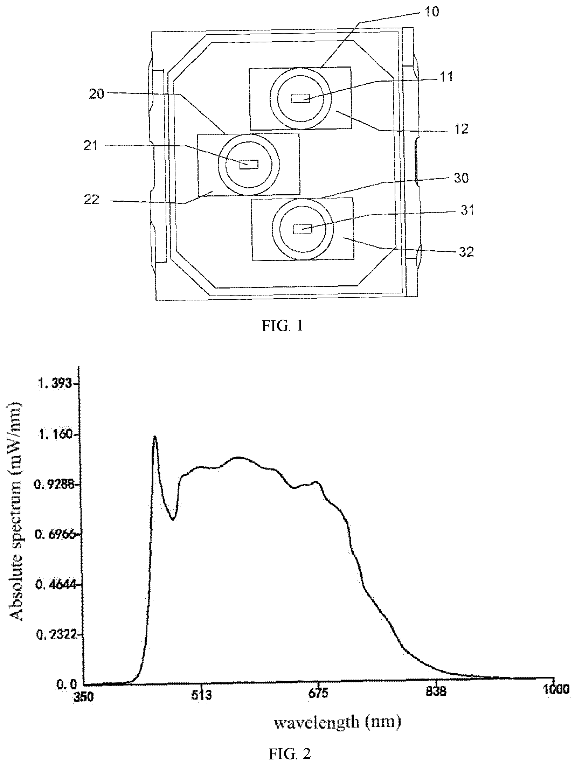

In some embodiments, as shown in FIG. 1, the full-color biomimetic light source of embodiments of the present application comprises a plurality of light-emitting units, specifically three, namely, the first light-emitting unit 10, the second light-emitting unit 20 and the third light-emitting unit 30.

Among them, the first light-emitting unit 10 comprises a first chip 11 and a first full-color biomimetic phosphor film 12, the second light-emitting unit 20 comprises a second chip 21 and a second full-color biomimetic phosphor film 22, and the third light-emitting unit 30 comprises a third chip 31 and a third full-color biomimetic phosphor film 32.

In some embodiments, the light emission wavelengths of the first chip 11, the second chip 21, and the third chip 31 may be 440 nm to 475 nm, optionally may be 440 nm to 460 nm, and further optionally may be 452 nm to 455 nm. The emission wavelengths of the three chips may be the same or different, and may be selected and adjusted according to the actual application. As in an exemplary embodiment, the emission wavelength of the first chip 11 may be 452 nm, the emission wavelength of the second chip 21 may be 455 nm, and the emission wavelength of the third chip 31 may be 458 nm. By adjusting the emission wavelength of the chip, the full-color biomimetic phosphor film contained in the full-color biomimetic light source of the embodiments of the present application may be stimulated to emit light, and the optical power of the blue in the band of 435 nm to 440 nm in the white light emitted by the full-color biomimetic light source of the embodiments of the application may be adjusted to reduce damage to the retina, and the spectral width of the white light in the range of 400 nm to 800 nm may be increased, and the color temperature of the light may be adjusted.

It should be noted that the emission wavelength of the chip refers to the wavelength at the peak of the main peak in the spectrum diagram of the light generated by the chip when it is excited by current.

In some embodiments, the first full-color biomimetic phosphor film 12, the second full-color biomimetic phosphor film 22, and the third full-color biomimetic phosphor film 32 are all full-color biomimetic phosphor films as described in the above embodiments of the present application. For example, it may be a composite film layer comprising a first film layer, a second film layer, and a third film layer, and the film thicknesses of the first film layer, the second film layer, and the third film layer may be further controlled to be 0.06 mm to 0.15 mm, respectively.

In a further embodiment, the first full-color biomimetic phosphor film 12 comprises: a first film layer, a second film layer, and a third film layer. The second full-color biomimetic phosphor film 22 comprises: a first film layer, a second film layer, and a third film layer. The third full-color biomimetic phosphor film 32 comprises: a first film layer, a second film layer, and a third film layer. A mass ratio of the first phosphor in the first film layer, the second phosphor in the second film layer, and the third phosphor in the third film layer may be (15 to 70): (15 to 70): (13 to 60), optionally may be (25 to 60): (25 to 55): (13 to 60), further optionally may be (31 to 40): (31 to 40): (13 to 60). In the first film layer, the concentration of the first phosphor may be 30% to 85%, optionally may be 40% to 75%, further optionally may be 60% to 69%. In the second film layer, the concentration of the second phosphor may be 30% to 85%, optionally may be 45% to 75%, further optionally may be 60% to 69%. In the third film layer, the concentration of the third phosphor may be 40% to 87%, optionally may be 50% to 80%, further optionally may be 60% to 69%.

In an exemplary embodiment, the emission wavelengths of the first chip 11, the second chip 21, and the third chip 31 are independently 440 nm to 460 nm; the first full-color biomimetic phosphor film 12 comprises: the first film layer, the second film layer, and the third film layer; the second full-color biomimetic phosphor film 22 comprises: the first film layer, the second film layer, and the third film layer; and the third full-color biomimetic phosphor film 32 comprises: the first film layer, the second film layer, and the third film layer. The mass ratio of the first phosphor in the first film layer, the second phosphor in the second film layer, and the third phosphor in the third film layer is (25 to 60): (25 to 55): (13 to 60). In the first film layer, the first phosphor accounts for 40% to 75% of the total mass of the film-forming material and the first phosphor,; in the second film layer, the second phosphor accounts for 45% to 75% of the total mass of the film-forming material and the second phosphor; and in the third film layer, the third phosphor accounts for 50% to 80% of the total mass of the film-forming material and the third phosphor.

In other embodiments, the first full-color biomimetic phosphor film 12, the second full-color biomimetic phosphor film 22, and the third full-color biomimetic phosphor film 32 are all the composite film layers comprising the fourth film layer and the fifth film layer as described in the above. In such condition, in the fourth film layer, the concentration of the first mixture may be 40% to 85%, optionally may be 40% to 80%, further optionally may be 40% to 75%; and in the fifth film layer, the concentration of the second mixture may be 15% to 85%, optionally may be 20% to 80%, and further optionally may be 30% to 75%.

In an exemplary embodiment, the emission wavelengths of the first chip 11, the second chip 21, and the third chip 31 are independently 440 nm to 460 nm, the first full-color biomimetic phosphor film 12 comprises the fourth film layer and the fifth film layer, the second full-color biomimetic phosphor film 22 comprises the fourth film layer and the fifth film layer, and the third full-color biomimetic phosphor film 32 comprises the fourth film layer and the fifth film layer. The mass ratio of the first mixture in the fourth film layer and the second mixture in the fifth film layer is (15 to 60): (20 to 80); in the fourth film layer, the first mixture accounts for 40% to 80% of the total mass of the first mixture and the film-forming material; and in the fifth film layer, the second mixture accounts for 20% to 80% of the total mass of the second mixture and the film-forming material.

In order to make the details and operations of the above embodiments of the present application clearly understood by those skilled in the art, and to demonstrate the significant performance improvement of the full-color biomimetic phosphor composition, full-color biomimetic phosphor film and full-color biomimetic light source in the embodiments of the present application, the above technical solution is illustrated by the following multiple examples.

### 1. Examples of full-color biomimetic phosphor compositions

### Example A1 to Example A4

Example A1 to Example A4 respectively provide full-color biomimetic phosphor compositions, and the particle sizes of the full-color biomimetic phosphor compositions are 10 µm to 25 µm.

Each of the full-color biomimetic phosphor compositions of Example A1 to Example A4 comprises: a first phosphor, a second phosphor, and a third phosphor, which are separately provided, and a mass ratio of the first phosphor, the second phosphor, and the third phosphor is shown in Table 1 below.

The first phosphor comprises a phosphor A2, and the phosphor A2 is Y₃(Al,Ga)₅O₁₂ with a light emission wavelength of 490 nm.

The second phosphor comprises a phosphor B1 and a phosphor B2. The phosphor B1 is BaSi₂O₂N₂ with a light emission wavelength of 525 nm, and the phosphor B2 is BaSi₂O₂N₂ with a light emission wavelength of 540 nm. Mass ratios of the phosphor B1 to the phosphor B2 are shown in Table 1.

The third phosphor comprises: a phosphor C1, a phosphor C2, a phosphor C3, a phosphor D, a phosphor E, and a phosphor F. The phosphor C1 is (Ca,Sr)AlSiN₃ with a light emission wavelength of 630 nm, the phosphor C2 is (Ca,Sr)AlSiN₃ with a light emission wavelength of 660 nm, the phosphor C3 is (Ca,Sr)AlSiN₃ with a light emission wavelength of 679 nm, the phosphor D is (Ca,Sr)AlSiN₃ with a light emission wavelength of 720 nm, the phosphor E is (Ca,Sr)AlSiN₃ with a light emission wavelength of 740 nm, and the phosphor F is (Ca,Sr)AlSiN₃ with a light emission wavelength of 795 nm. Mass ratios of the phosphor C1, the phosphor C2, the phosphor C3, the phosphor D, the phosphor E, and the phosphor F are detailed in Table 1 below.

**Table 1**

| Example | Mass ratio of phosphor B1 (525nm) to phosphor B2 (540nm) in second phosphor (B1:B2) | Mass ratio of phosphors C1 (630nm), C2 (660nm), C3 (679nm), D (720nm), E (740nm), and F (795nm) in third phosphor (C1:C2:C3:D:E:F) | Mass ratio of first phosphor (A2, 490nm), second phosphor, and third Phosphor |
|---|---|---|---|
| Example A1 | 50:45 | 12:15:23:50:35:25 | 45:45:40 |
| Example A2 | 20:10 | 7:3:3:20:20:1 | 15:70:70 |
| Example A3 | 20:85 | 7:30:40:80:50:50 | 70:15:13 |
| Example A4 | 85:10 | 20:30:40:30:30:15 | 30:50:45 |

### Example A5 to Example A8

Example A5 to Example A8 provide full-color biomimetic phosphor compositions, respectively. The full-color biomimetic phosphor compositions of Example A5 to Example A8 are substantially the same as the full-color biomimetic phosphor compositions of Example A1 to Example A4, respectively, that is, the full-color biomimetic phosphor composition of Example A5 is the same as the full-color biomimetic phosphor composition of Example A1, this pattern continues accordingly, the full-color biomimetic phosphor composition of Example A8 is the same as the full-color biomimetic phosphor composition of Example A4.

The main difference between the full-color biomimetic phosphor compositions of Example A5 to Example A8 and the full-color biomimetic phosphor compositions of Example A1 to A4 is that the first phosphor, the second phosphor, and the third phosphor form a mixture in the full-color biomimetic phosphor compositions of Example A5 to Example A8.

### Example A9 to Example A14

Example A9 to Example A14 respectively provide full-color biomimetic phosphor compositions, and the particle sizes of the full-color biomimetic phosphor composition are 10 µm to 25 µm.

The full-color biomimetic phosphor compositions of Example A9 to Example A14 comprise a first mixture and a second mixture which are separately provided.

The first mixtures of Example A9 to Example A13 comprise: a phosphor A2, a phosphor B3, and a phosphor C2, and mass ratios thereof are shown in Table 2. The phosphor B3 is BaSi₂O₂N₂ with a light emission wavelength of 535 nm. The phosphor A2 and the phosphor C2 are the same as phosphor A2 and the phosphor C2 of Example A1.

The first mixture of Example A14 comprises: a phosphor A1, a phosphor A2, a phosphor B3, a phosphor B4, a phosphor C1, and a phosphor C2, and mass ratios thereof are shown in Table 2. The phosphor A1 is Y₃(Al,Ga)₅O₁₂ with an emission wavelength of 480 nm, and the phosphor B4 is silicate Ba₂(YxLayEu1xy)₈(SiO₄)₆O₂ with an emission wavelength of 600 nm.

The second mixtures of Example A9 to Example A14 comprise: a phosphor D, a phosphor E, and a phosphor F, and their mass ratios are detailed in Table 2. The phosphor D, the phosphor E, and the phosphor F are the same as the phosphor D, the phosphor E, and the phosphor F in Example A1.

### Example A15 to Example A17

Example A15 to Example A17 respectively provide full-color biomimetic phosphor compositions. The particle sizes of Example A15 to Example A17 are independently 10 µm to 25 µm. The full-color biomimetic phosphor compositions of Example A15 and Example A16 comprise: a phosphor A2, a phosphor B5, a phosphor C2, and a phosphor E mixed with each other, and their mass ratios are detailed in Table 2 below. The phosphor B5 is BaSi₂O₂N₂ with a emission wavelength of 530 nm.

The full-color biomimetic phosphor composition of Example A17 comprises: a phosphor A2, a phosphor B3, a phosphor C3, and a phosphor E mixed with each other, and the mass ratio thereof is detailed in Table 2 below. The phosphor B3 is the same as phosphor B3 in Example A9.

The phosphor A2, the phosphor C3, and the phosphor E in Examples A15 to A17 are the same as the phosphor A2, the phosphor C3, and the phosphor E in Example A1.

**Table 2**

| Item | First mixture | Mass ratio of phosphor D(720 nm), phosphor E (740 nm), and phosphor F (795 nm) in second mixture (D:E:F) | |
|---|---|---|---|
| Example A9 | Mass ratio of phosphor A2 (490 nm) : phosphor B3 (535 nm) : phosphor C2 (660 nm) (A: B3: C2) | 38:50:15 | 65:40:35 |
| Example A10 | | 15:85:30 | 40:60:70 |
| Example A11 | | 60:20:1 | 90:20:1 |
| Example A12 | | 80:85:40 | 120:90:100 |
| Example A13 | | 17:78.5:4.5 | 70:30:0 |
| Example A14 | Mass ratio of phosphor A1 (480 nm) : phosphor A2 (490 nm) : phosphor B3 (535 nm) : phosphor B4 (600 nm) : phosphor C1 (630 nm) : phosphor C2 (660 nm) (A1: A2: B3: B4: C1: C2) | 18.62: 22.32: 74.73: 8.62: 6.16: 3.17 | 30:70:0 |
| Item | Mass ratio of phosphor A2 (490 nm) : phosphor B5 (530 nm) : phosphor C2 (660 nm) : phosphor E (740 nm) (A2: B5: C2: E) | | |
| Example A15 | 19:71:6:20 | | |
| Example A16 | 19:71:6:20 | | |
| | Mass ratio of phosphor A2 (490 nm), phosphor B3 (535 nm), phosphor C3 (679 nm), and phosphor E (740 nm) in full-color biomimetic phosphor composition (A2:B3:C3:E) | | |
| Example A17 | 16:79:9:20 | | |

### Comparative Example A1

This comparative example provides a full-color biomimetic phosphor composition, and a particle size of the full-color biomimetic phosphor composition is 10 µm to 25 µm. The phosphor combination of this comparative example comprises: a phosphor B, a phosphor C1, a phosphor C2, a phosphor C3, a phosphor D, a phosphor E, and a phosphor F, which are mixed with each other in a mass ratio of 20:20:20:2:32:6:0.

The phosphor B3 of this comparative example is the same as the phosphor B3 of Example A9, and the phosphor C1, the phosphor C2, the phosphor C3, the phosphor D, the phosphor E, and the phosphor F of this comparative example are the same as the phosphor C1, the phosphor C2, the phosphor C3, the phosphor D, the phosphor E, and the phosphor F of Example A1.

### Comparative Example A2

This comparative example provides a full-color biomimetic phosphor composition, and a particle size of the full-color biomimetic phosphor composition is 10 µm to 25 µm. The full-color biomimetic phosphor composition of this comparative example comprises: a first mixture and a second mixture that are separated from each other.

The first mixture comprises: a phosphor B3, a phosphor C1, and a phosphor C2 in a mass ratio of 10:50:40, and the second mixture comprises: a phosphor C3, a phosphor D, a phosphor E, and a phosphor F in a mass ratio of 20:40:40:0.

The phosphor B3, the phosphor C1, the phosphor C2, the phosphor C3, the phosphor D, the phosphor E, and the phosphor F in this comparative example are the same as the phosphor B3, the phosphor C1, the phosphor C2, the phosphor C3, the phosphor D, the phosphor E, and the phosphor F in comparative example A1.

### 2. Examples of full-color biomimetic phosphor films

### Example B1 to Example B4

Examples B1 to B4 respectively provide full-color biomimetic phosphor films. The full-color biomimetic phosphor film has a three-layer film structure, comprising a first film layer, a second film layer, and a third film layer stacked in sequence. The first film layer comprises: a first phosphor and a silica gel as a film-forming material, the second film layer comprises a second phosphor and a silica gel as a film-forming material, and the third film layer comprises a third phosphor and a silica gel as a film-forming material.

In Example B1, the first phosphor is the first phosphor in Example A1, the second phosphor is the second phosphor in Example A1, and the third phosphor is the third phosphor in Example A1. In Example B2, the first phosphor is the first phosphor in Example A2, the second phosphor is the second phosphor in Example A2, and the third phosphor is the third phosphor in Example A2; this pattern continues accordingly; and in Example B4, the first phosphor is the first phosphor in Example A4, the second phosphor is the second phosphor in Example A4, and the third phosphor is the third phosphor in Example A4.

The film-forming method of the full-color biomimetic phosphor film of Examples B1 to B4, the film thickness of the first film layer and the concentration of the first phosphor, the film thickness of the second film layer and the concentration of the second phosphor, and the film thickness of the third film layer and the concentration of the third phosphor are detailed in Table 3.

### Example B5 to Example B8 and Example B15 to Example B17

Examples B5 to B8 and Examples B15 to B17 respectively provide full-color biomimetic phosphor films. The full-color biomimetic phosphor films are single film structures and comprise a full-color biomimetic phosphor composition and a silica gel as a film-forming material. The film-forming methods, the film thicknesses, and the concentrations of the full-color biomimetic phosphor compositions of these full-color biomimetic phosphor films are shown in Table 3.

The full-color biomimetic phosphor composition in Example B5 is the full-color biomimetic phosphor composition in Example A5, this pattern continues accordingly. The full-color biomimetic phosphor composition in Example B8 is the full-color biomimetic phosphor composition in Example A8, the full-color biomimetic phosphor composition in Example B15 is the full-color biomimetic phosphor composition in Example A15, and the full-color biomimetic phosphor composition in Example B17 is the full-color biomimetic phosphor composition in Example A17.

### Example B9 to Example B14

Example B9 to Example B12 respectively provide full-color biomimetic phosphor films. The full-color biomimetic phosphor film has a double-layer film structure and comprises a fourth film layer and a fifth film layer. The fourth film layer comprises a silica gel as a film-forming material and the first mixture, and the fifth film layer comprises a silica gel as a film-forming material and the second mixture.

In Example B9, the first mixture is the first mixture in Example A9, and the second mixture is the second mixture in Example A9; in Example B10, the first mixture is the first mixture in Example A10, and the second mixture is the second mixture in Example A10; this pattern continues accordingly, in Example B12, the first mixture is the first mixture in Example A12, and the second mixture is the second mixture in Example A12.

The film-forming methods of the full-color biomimetic phosphor films of Example B9 to Example B12, the film thicknesses and the concentrations of the fourth film layers, and the film thicknesses and the concentrations of the second mixtures of the fifth film layers are detailed in Table 3.

### Comparative Example B1

This comparative example provides a full-color biomimetic phosphor film. The full-color biomimetic phosphor film provided in this comparative example is a single film structure, comprising a single film, which comprises a silica gel as a film-forming material and a full-color biomimetic phosphor composition provided in Comparative Example A1. The film thickness of the full-color biomimetic phosphor film provided in this comparative example is 0.20 mm, and the concentration of the full-color biomimetic phosphor composition is 68%.

### Comparative Example B2

This comparative example provides a full-color biomimetic phosphor film. The full-color biomimetic phosphor film in this comparative example is different from the full-color biomimetic phosphor film in Example B9 in that: 1, in this comparative example, the first mixture is the first mixture in Comparative Example A2, and the second mixture is the second mixture in Comparative Example A2; 2, in this comparative example, the concentration of the first mixture in the fourth film layer and the concentration of the second mixture in the fifth film layer are the concentrations shown in Table 3.

The film thickness and the concentration of the first mixture of the fourth phosphor film in this comparative example, as well as the film thickness and the concentration of the second mixture of the fifth phosphor film, are detailed in Table 3.

**Table 3**

| Exam ple | Film-formi ng meth od | Three-layer film structure | | | | | | Single-layer film structur e | | Double-layer film structure | | | |
|---|---|---|---|---|---|---|---|---|---|---|---|---|---|
| | | First film layer | | Second film layer | | Third film layer | | | | Fourth film layer | | Fifth film layer | |
| | | Thi ckn ess (m m) | Con cent ratio n (%) | Thi ckn ess (m m) | Con cent ratio n (%) | Thi ckn ess (m m) | Con cent ratio n (%) | T hi ck ne ss ( m m ) | Co nce ntr atio n (%) | Thi ckn ess (m m) | Con cent ratio n (%) | Thi ckn ess (m m) | Con cent ratio n (%) |
| B1 | Film press ing | 0.1 3 | 64 | 0.1 3 | 64 | 0.1 3 | 64 | - | - | - | - | - | - |
| B2 | Film press ing | 0.0 6 | 87 | 0.0 6 | 85 | 0.0 6 | 85 | - | - | - | - | - | - |
| B3 | Spra y coati ng | 0.0 03 | 40 | 0.0 03 | 50 | 0.0 03 | 60 | - | - | - | - | - | - |
| B4 | Spra y coati ng | 0.0 1 | 70 | 0.0 1 | 70 | 0.0 1 | 70 | - | - | - | - | - | - |
| B5 | Film | - | - | - | - | - | - | 0. | 60 | - | - | - | - |
| | press ing | | | | | | | 06 | | | | | |
| B6 | Film press ing | - | - | - | - | - | - | 0. 15 | 69 | - | - | - | - |
| B7 | Film press ing | - | - | - | - | - | - | 0. 00 6 | 55 | - | - | - | - |
| B8 | Film press ing | - | - | - | - | - | - | 0. 00 2 | 63 | - | - | - | - |
| B9 | Film press ing | - | - | - | - | - | - | - | - | 0.1 0 | 55 | 0.1 0 | 45 |
| B10 | Film press ing | - | - | - | - | - | - | - | - | 0.1 0 | 40 | 0.1 0 | 30 |
| B11 | Film press ing | - | - | - | - | - | - | - | - | 0.1 0 | 80 | 0.1 0 | 20 |
| B12 | Film press ing | - | - | - | - | - | - | - | - | 0.1 0 | 75 | 0.1 0 | 15 |
| B13 | Film press ing | | | | | | | | | 0.1 0 | 61 | 0.1 0 | 65 |
| B14 | Film press ing | | | | | | | | | 0.1 0 | 56 | 0.1 0 | 69 |
| B15 | | | | | | | | 0. 20 | 67 | | | | |
| B16 | | | | | | | | 0. 20 | 67 | | | | |
| B17 | | | | | | | | 0. 20 | 67 | | | | |
| Comp arative Exam ple B1 | Film press ing | - | - | - | - | - | - | 0. 20 | 68 | - | - | - | - |
| Comp arative Exam ple B2 | Film press ing | - | - | - | - | - | - | - | - | 0.1 0 | 61 | 0.1 0 | 63 |

### 3. Examples of full-color biomimetic light sources

### Examples C1 to Example C15

Examples C1 to C15 provide full-color biomimetic light sources, each comprising: a first light-emitting unit, a second light-emitting unit, and a third light-emitting unit.

The first light-emitting unit comprises a first chip and a first full-color biomimetic phosphor film, the second light-emitting unit comprises a second chip and a second full-color biomimetic phosphor film, and the third light-emitting unit comprises a third chip and a third full-color biomimetic phosphor film.

The first full-color biomimetic phosphor film, the second full-color biomimetic phosphor film, and the third full-color biomimetic phosphor film in Example C1 are all the full-color biomimetic phosphor films in Example B1. The first full-color biomimetic phosphor film, the second full-color biomimetic phosphor film, and the third full-color biomimetic phosphor film in Example C2 are all the full-color biomimetic phosphor films in Example B2. This pattern continues accordingly. The first full-color biomimetic phosphor film, the second full-color biomimetic phosphor film, and the third full-color biomimetic phosphor film in Example C14 are all the full-color biomimetic phosphor films in Example B14.

In the full-color biomimetic light source of Example C15, the first full-color biomimetic phosphor film is the full-color biomimetic phosphor film in Example B15, the second full-color biomimetic phosphor film is the full-color biomimetic phosphor film in Example B16, and the third full-color biomimetic phosphor film is the full-color biomimetic phosphor film in Example B17.

The light-emitting wavelengths of the first chip, the second chip, and the third chip in Examples C1 to C15 are shown in Table 4 below.

### Comparative Example C1 and Comparative Example C2

Example C1 and Example C2 respectively provide a full-color biomimetic light source. The full-color biomimetic light source comprises a light-emitting unit. The light-emitting unit comprises a chip and a full-color biomimetic phosphor film. The full-color biomimetic phosphor film in Comparative Example C1 is the full-color biomimetic phosphor film in Comparative Example B1, and the full-color biomimetic phosphor film in Comparative Example C2 is the full-color biomimetic phosphor film in Comparative Example B2. The light-emitting wavelengths of the chips in Comparative Example C1 and Comparative Example C2 are shown in Table 4 below.

**Table 4**

| Item | Wavelength of first chip (nm) | Wavelength of second chip (nm) | Wavelength of third chip (nm) |
|---|---|---|---|
| Example C1 | 452 | 452 | 452 |
| Example C2 | 440 | 440 | 440 |
| Example C3 | 455 | 455 | 455 |
| Example C4 | 460 | 460 | 460 |
| Example C5 | 470 | 470 | 470 |
| Example C6 | 452 | 455 | 458 |
| Example C7 | 455 | 455 | 455 |
| Example C8 | 455 | 455 | 455 |
| Example C9 | 455 | 455 | 455 |
| Example C10 | 455 | 455 | 455 |
| Example C11 | 455 | 455 | 455 |
| Example C12 | 455 | 455 | 455 |
| Example C13 | 455 | 455 | 455 |
| Example C14 | 452 | 452 | 452 |
| Example C15 | 452 | 455 | 465 |
| Comparative Example C1 | 455 | - | - |
| Comparative Example C2 | 455 | - | - |

### Spectral tests of light sources:

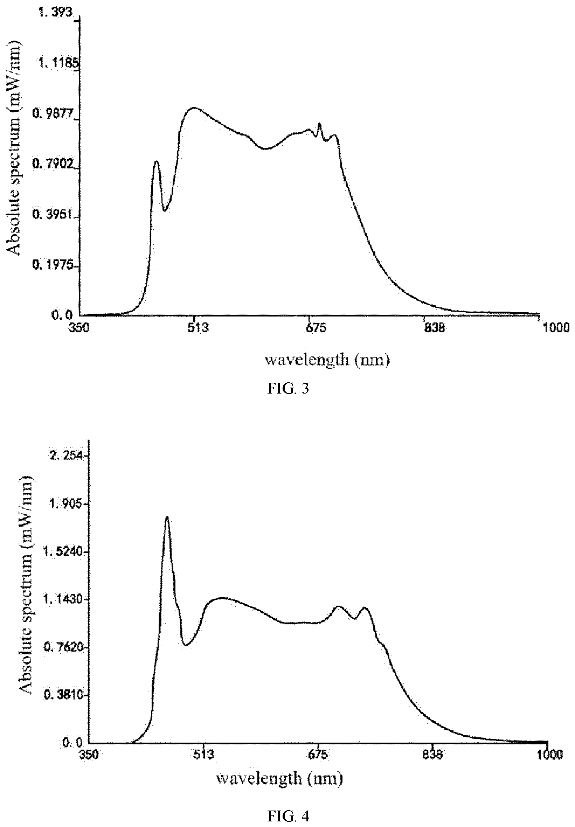

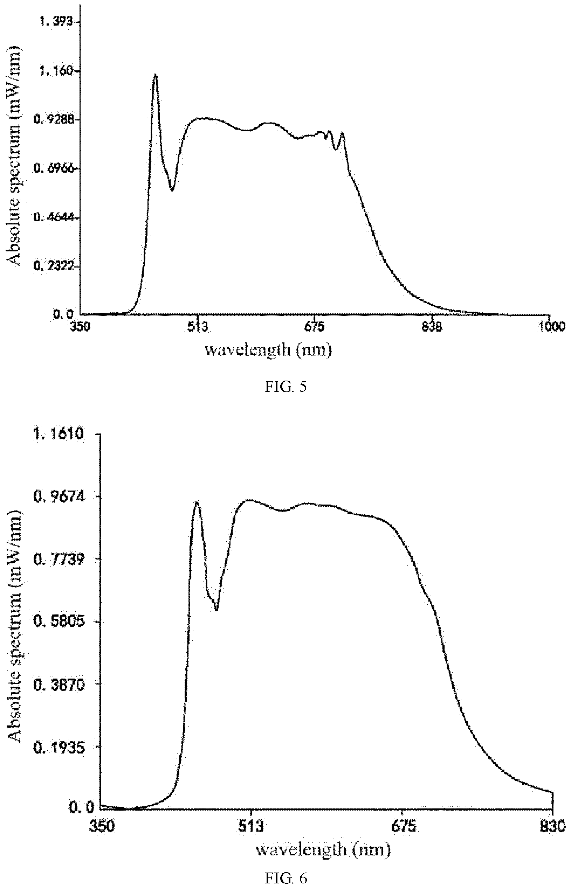

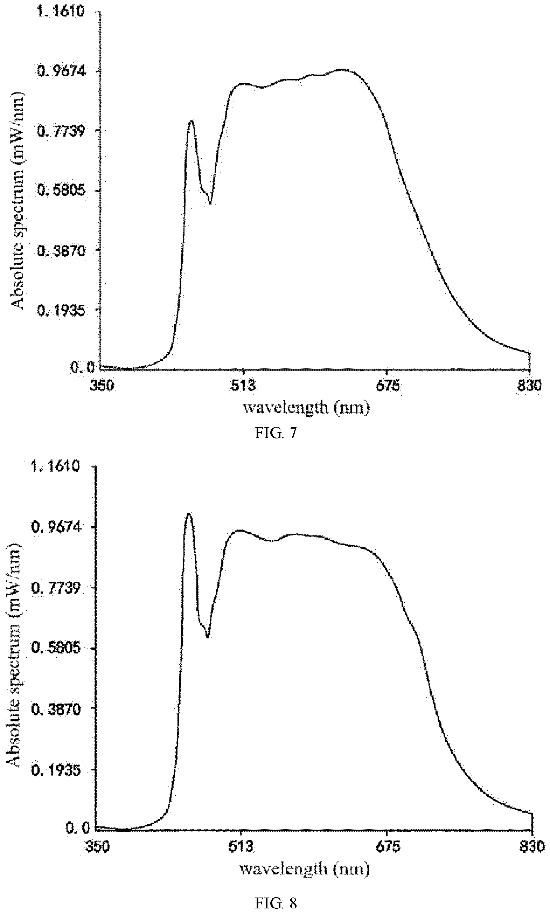

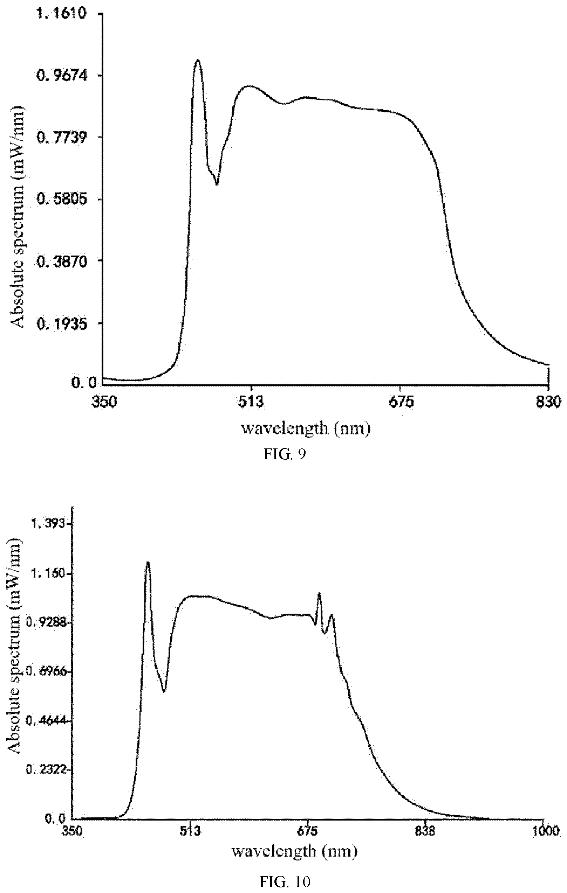

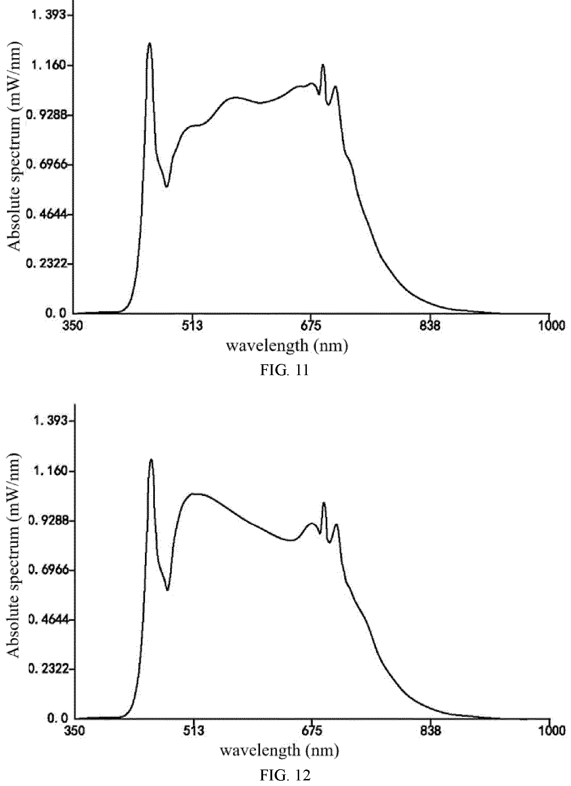

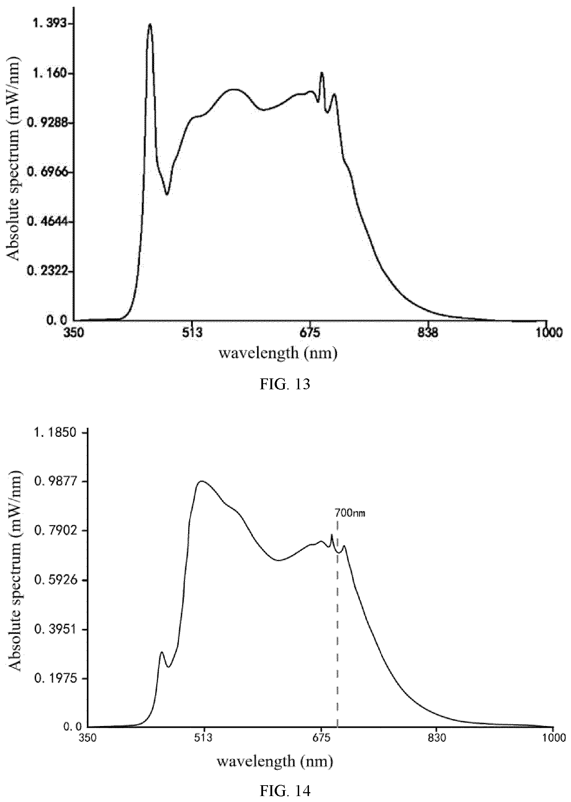

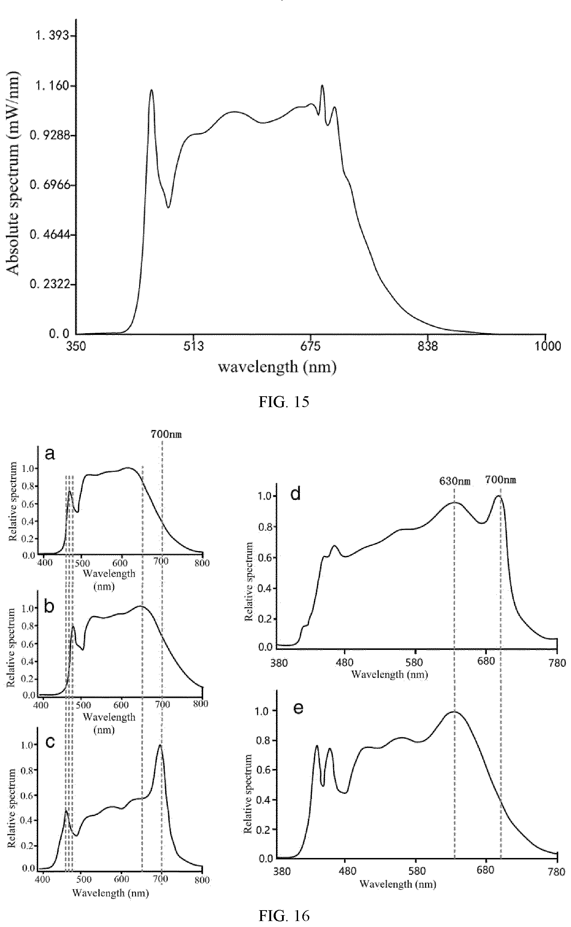

The full-color biomimetic light sources of the above-mentioned Examples C1 to C15, Comparative Examples C1 and C2 were subjected to spectral tests respectively, and the results are shown in FIGS. 2-18.

As shown in FIGS. 2-16, the spectrum of white light generated by the full-color biomimetic light source provided by Examples C1 to C15 of the present application is highly similar to the spectrum of natural light. The white light comprises all visible light in the 400 nm to 700 nm band, and the absolute optical power value of the purple light in a band of 380 nm to 435 nm of the white light is small, the absolute optical power value of the cyan light in a band of 475 nm to 492 nm is large, and the absolute optical power value of the cyan light in a band of 475 nm to 492 nm is large. The average optical power of visible light in different bands is close to that of natural light, so that the white light highly simulates natural light, has a high color rendering index, is less harmful to the human body, and makes the human body feel comfortable. The optical power value of the red light part in the composite spectrum of the first to third light-emitting units contained in the light source of Example C15 is significantly higher than the optical power value of the red light part in the spectrum of the existing dual-chip low-blue light full-spectrum light source.

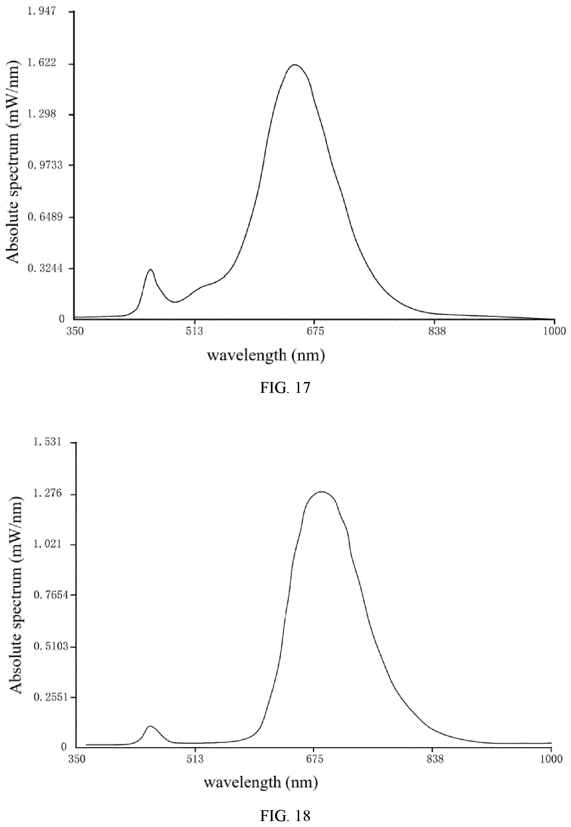

As shown in FIGS. 17-18, the white light generated by the full-color biomimetic light source provided by Comparative Examples C1 and C2 has high optical power in the red light band, especially in the 600 to 700 nm band, and low optical power in the 500 to 600 nm band. The white light generated by the full-color biomimetic light source provided by Comparative Examples C1 and C2 is greatly different from natural light.

## Claims

1. **A full-color** biomimetic phosphor composition, wherein the full-color biomimetic phosphor composition comprises:
a first phosphor, wherein an emission wavelength of the first phosphor is 480 nm to 500 nm;
a second phosphor, wherein an emission wavelength of the second phosphor is greater than 500 nm and smaller than 620 nm;
a third phosphor, wherein an emission wavelength of the third phosphor is greater than or equal to 620 nm;
wherein
a mass ratio of the first phosphor, the second phosphor, and the third phosphor is (15 to 70) : (15 to 70) : (13 to 70);
a first phosphor comprises a phosphor A, and an emission wavelength of the phosphor A is 480 nm and/or 488 nm to 492 nm;
the second phosphor comprises a phosphor B, and an emission wavelength of the phosphor B is 523 nm to 542 nm; and
the third phosphor comprises: a phosphor C, a phosphor D, a phosphor E, and a phosphor F; an emission wavelength of the phosphor C is 628 nm to 681 nm, an emission wavelength of the phosphor D is 718 nm to 722 nm, an emission wavelength of the phosphor E is 738 nm to 742 nm, and an emission wavelength of the phosphor F is 793 nm to 797 nm.

2. The full-color biomimetic phosphor composition according to claim 1, wherein the first phosphor, the second phosphor, and the third phosphor are provided separately;
the phosphor B in the second phosphor comprises a phosphor B1 and a phosphor B2; an emission wavelength of the phosphor B1 is 523 nm to 527 nm; an emission wavelength of the phosphor B2 is 538 nm to 542 nm; and a mass ratio of the phosphor B1 to the phosphor B2 is (20 to 85) : (10 to 85); and
the phosphor C in the third phosphor comprises: a phosphor C1, a phosphor C2, and a phosphor C3; an emission wavelength of the phosphor C1 is 628 nm to 632 nm, an emission wavelength of the phosphor C2 is 658 nm to 662 nm, and an emission wavelength of the phosphor C3 is 677 nm to 681 nm; and a mass ratio of the phosphor C1, the phosphor C2, the phosphor C3, the phosphor D, the phosphor E, and the phosphor F is (3 to 35) : (1 to 45) : (3 to 60) : (7 to 90) : (7 to 60) : (1 to 70).

3. The full-color biomimetic phosphor composition according to claim 1, wherein
the phosphor C in the third phosphor forms a first mixture with the first phosphor and the second phosphor;
the phosphor D, the phosphor E, and the phosphor F in the third phosphor form a second mixture;
in the first mixture, a mass ratio of the phosphor A, the phosphor B, and the phosphor C is (10 to 80) : (15 to 85) : (1 to 40);
in the second mixture, a mass ratio of the phosphor D, the phosphor E, and the phosphor F is (20 to 120) : (10 to 90) : (1 to 100); and
the first mixture and the second mixture are provided separately.

4. The full-color biomimetic phosphor composition according to any one of claims 1-3, wherein particle sizes of the first phosphor, the second phosphor, and the third phosphor are independently smaller than or equal to 50 µm.

5. A full-color biomimetic phosphor film, wherein the full-color biomimetic phosphor film comprises a film-forming material and the full-color biomimetic phosphor composition according to any one of claims 1-4 dispersed in the film-forming material.

6. The full-color biomimetic phosphor film according to claim 5, wherein the full-color biomimetic phosphor composition is the full-color biomimetic phosphor composition according to any one of claims 1-2, the full-color biomimetic phosphor film comprises: a first film layer, a second film layer, and a third film layer, which are stacked, the first film layer comprises the first phosphor, the second film layer comprises the second phosphor, and the third film layer comprises the third phosphor.

7. The full-color biomimetic phosphor film according to claim 6, wherein
in the first film layer, the first phosphor accounts for 30% to 85% of a total mass of the film-forming material and the first phosphor; and/or
in the second film layer, the second phosphor accounts for 30% to 85% of a total mass of the film-forming material and the second phosphor; and/or
in the third film layer, the third phosphor accounts for 40% to 87% of a total mass of the film-forming material and the third phosphor; and/or
the full-color biomimetic phosphor film is prepared by a film pressing method, and a film thickness of any one of the first film layer, the second film layer, and the third film layer is 0.06 mm to 0.15 mm; or altematively, the full-color biomimetic phosphor film is prepared by a spray coating method, and a film thickness of any one of the first film layer, the second film layer, and the third film layer is 0.001 mm to 0.01 mm.

8. The full-color biomimetic phosphor film according to claim 5, wherein the full-color biomimetic phosphor composition is the full-color biomimetic phosphor composition according to claim 3, the full-color biomimetic phosphor film comprises a fourth film layer and a fifth film layer which are stacked, the fourth film layer comprises the first mixture, the fifth film layer comprises the second mixture, wherein particle sizes of the first phosphor, the second phosphor, and the third phosphor are independently smaller than or equal to 50 µm.

9. The full-color biomimetic phosphor film according to claim 8, wherein
in the fourth film layer, the first mixture accounts for 40% to 85% of a total mass of the film-forming material and the first mixture; and/or
in the fifth film layer, the second mixture accounts for 15% to 85% of a total mass of the film-forming material and the second mixture; and/or
the full-color biomimetic phosphor film is prepared by a film pressing method and a film thickness of any one of the fourth film layer and the fifth film layer is 0.06 mm to 0.15 mm, or alternatively, the full-color biomimetic phosphor film is prepared by a spray coating method and a film thickness of any one of the fourth film layer and the fifth film layer is 0.001 mm to 0.01 mm.

10. A full-color biomimetic light source, comprising at least one light-emitting unit, the light-emitting unit comprising a chip and a full-color biomimetic phosphor film arranged on an optical path of the chip, the full-color biomimetic phosphor film being the full-color biomimetic phosphor film according to any one of claims 5-9.

11. The full-color biomimetic light source according to claim 10, wherein the full-color biomimetic phosphor film is the full-color biomimetic phosphor film according to any one of claims 6-9, and the following conditions are satisfied:
a layer with a smallest light refractive index among the first film layer, the second film layer, and the third film layer is arranged close to the chip, or alternatively, a layer with a smallest light refractive index among the fourth film layer and the fifth film layer is arranged close to the chip; and
a light emission wavelength of the chip is 440 nm to 475 nm.

12. The full-color biomimetic light source according to claim 11, wherein the full-color biomimetic light source comprises the following three light-emitting units:
a first light-emitting unit, comprising: a first chip, and a first full-color biomimetic phosphor film arranged on an optical path of the first chip;
a second light-emitting unit, comprising: a second chip, and a second full-color biomimetic phosphor film arranged on an optical path of the second chip; and
a third light-emitting unit, comprising: a third chip, and a third full-color biomimetic phosphor film arranged on an optical path of the third chip.

13. The full-color biomimetic light source according to claim 12, wherein
emission wavelengths of the first chip, the second chip, and the third chip are independently 440 nm to 460 nm; and
the first full-color biomimetic phosphor film comprises: the first film layer, the second film layer, and the third film layer; the second full-color biomimetic phosphor film comprises: the first film layer, the second film layer, and the third film layer; the third full-color biomimetic phosphor film comprises: the first film layer, the second film layer, and the third film layer; a mass ratio of the first phosphor in the first film layer, the second phosphor in the second film layer, and the third phosphor in the third film layer is (25 to 60) : (25 to 55) : (13 to 60); in the first film layer, the first phosphor accounts for 40% to 75% of a total mass of the film-forming material and the first phosphor; in the second film layer, the second phosphor accounts for 45% to 75% of a total mass of the film-forming material and the second phosphor; and in the third film layer, the third phosphor accounts for 50% to 80% of a total mass of the film-forming material and the third phosphor.

14. The full-color biomimetic light source according to claim 12, wherein emission wavelengths of the first chip, the second chip, and the third chip are independently 440 nm to 460 nm; and
the first full-color biomimetic phosphor film comprises the fourth film layer and the fifth film layer,
the second full-color biomimetic phosphor film comprises the fourth film layer and the fifth film layer,
the third full-color biomimetic phosphor film comprises the fourth film layer and the fifth film layer,
a mass ratio of the first mixture in the fourth film layer to the second mixture in the fifth film layer is (15 to 60) : (20 to 80),
in the fourth film layer, the first mixture accounts for 40% to 80% of a total mass of the first mixture and the film-forming material, and
in the fifth film layer, the second mixture accounts for 20% to 80% of a total mass of the second mixture and the film-forming material.

15. The full-color biomimetic light source according to any one of claims 10-14, wherein a white light generated by the full-color biomimetic light source has any of the following spectral characteristics:
an absolute spectral power value of a violet light in a band of 380 nm to 435 nm is smaller than 0.45;
an absolute spectral power value of a blue light in a band of 435 nm to 475 nm is greater than 0.40 and smaller than 0.80;
an absolute spectral power value of a cyan light in a band of 475 nm to 492 nm is greater than 0.30;
an absolute spectral power value of an orange light in a band of 597 nm to 622 nm is greater than 0.80; and
an absolute spectral power value of a red light in a band of 622 nm to 700 nm is greater than 0.70.

16. The full-color biomimetic light source according to claim 15, wherein
a color temperature of a white light is smaller than 4000K, an absolute spectral power value of a green light in a band of 492 nm to 577 nm is smaller than 0.70, and an absolute optical power value of a yellow light in a band of 577 nm to 597 nm is smaller than 0.80; or alternatively,
a color temperature of the white light is greater than or equal to 4000K, an absolute spectral power value of a green light in a band of 492 nm to 577 nm is greater than 0.65, and an absolute optical power value of a yellow light in a band of 577 nm to 597 nm is greater than 0.80.
